(19) Europäisches Patentamt

European Patent Office

Office européen des brevets

(11) Veröffentlichungsnummer: **0 509 118 A1**

## (12) EUROPÄISCHE PATENTANMELDUNG

(21) Anmeldenummer: **91106191.9**

(22) Anmeldetag: **18.04.91**

(51) Int. Cl.5: **H03K 17/10**

| | |
|---|---|
| Ein Antrag gemäss Regel 88 EPÜ auf Hinzufügung liegt vor. Über diesen Antrag wird im Laufe des Verfahrens von der Prüfungsabteilung eine Entscheidung getroffen werden (Richtlinien für die Prüfung im EPA, A-V, 2.2). | **AT BE CH DE DK ES FR GB GR IT LI LU NL SE** |
| | (71) Anmelder: **ASEA BROWN BOVERI AG** |
| | **CH-5401 Baden(CH)** |
| (43) Veröffentlichungstag der Anmeldung: **21.10.92 Patentblatt 92/43** | (72) Erfinder: **Grüning, Horst, Dr.** **Heimstrasse 2** **CH-5430 Wettingen(CH)** |
| (84) Benannte Vertragsstaaten: | |

(54) **Schaltungsanordnung mit einer Serieschaltung von abschaltbaren Hochleistungs-Halbleiterbauelementen in Form von GTO-Bauelementen.**

(57) Bei einer Schaltungsanordnung mit in Serie geschalteten GTO-Bauelementen (G5,...,G7) wird eine Vereinfachung der Schaltung und eine Reduktion in der Dimensionierung der Beschaltungselemente dadurch erreicht, dass die Unterschiede in den Schaltverzögerungszeiten $t_d$ der einzelnen GTO-Bauelemente (G5,...,G7) durch eine "harte" Ansteuerung mittels geeigneter Gate-Units (GU1,...,GU3) auf ein unkritisches Mass verringert werden.

FIG. 2

EP 0 509 118 A1

## TECHNISCHES GEBIET

Die vorliegende Erfindung bezieht sich auf das Gebiet der Leistungselektronik. Sie betrifft insbesondere eine Schaltungsanordnung mit einer Serieschaltung von abschaltbaren Hochleistungs-Halbleiterbauelementen in Form von GTO-Bauelementen, wobei

(a) jedem der GTO-Bauelemente jeweils ein Gate-Unit zur Ansteuerung zugeordnet ist, welcher einen Gatestrom $I_G$ abgibt;

(b) jedem der GTO-Bauelemente jeweils ein Snubber parallelgeschaltet ist, welcher die Anstiegsgeschwindigkeit der Sperrspannung dV/dt beim Abschalten begrenzt und einen Snubber-Kondensator und eine Snubber-Diode umfasst;

(c) Induktivitäten mit den GTO-Bauelementen in Serie geschaltet sind, welche die Anstiegsgeschwindigkeit des Durchlassstromes dl/dt beim Einschalten begrenzen; und

(d) die GTO-Bauelemente während des Betriebs gemeinsam ein- bzw. abgeschaltet werden;

Eine solche Schaltungsanordnung ist z.B. aus dem Artikel von H. Saotome et al., ....) bekannt.

## STAND DER TECHNIK

Bei verschiedenen Hochleistungsanwendungen (HGÜ, SVC, transformatorlose oder Mehrsystemloks) kann die Serieschaltung von abschaltbaren Hochleistungs-Halbleiterbauelementen (GTO, HF-GTO, SITh, FCTh) deutliche Vorteile gegenüber derzeit verwendeten Lösungen bringen. Erste Anwendungen und Erfahrungen mit derartigen Serieschaltungen sind in der eingangs genannten Druckschrift bereits eingehend beschrieben worden.

Speziell in der Serieschaltung aber führen die Eigenschaften herkömmlicher GTOs, die mit herkömmlicher Ansteuerung betrieben werden, zu massivem Schaltungsaufwand und erheblichen Mehrverlusten. Verursacher sind dabei hauptsächlich

(1) die unkontrollierbaren Unterschiede in den Schaltverzögerungszeiten $t_d$ der einzelnen Bauelemente in der Serieschaltung;

(2) die notwendige Begrenzung für die Anstiegsgeschwindigkeit des Durchlassstromes dl/dt, die zusammen mit (1) zu neuen Problemen führt; und

(3) die kleinen zulässigen Werte für die Anstiegsgeschwindigkeit der Sperrspannung dV/dt, welche erhebliche Verluste im Snubber hervorrufen.

Bei Anwendungen mit Spannungen von wenigen kV (wie z.B. SVC-Anwendungen) können die Probleme noch einigermassen realistisch mit einem gemeinsamen Clamp (Clamp-Dioden Dc1,...,DC4 und Clamp-Kondensator CC in Fig. 1 dieser Anmeldung bzw. in Fig. 2 der eingangs genannten Druckschrift) gelöst werden. Bei HGÜ dagegen würde sich wegen der hohen Spannungen (500 kV - $\geq$1 MV) eine solche Lösung gänzlich verbieten.

Aufgabe der vorliegenden Erfindung ist es daher, eine Schaltungsanordnung für die Serieschaltung von GTO-Bauelementen - im Rahmen dieser Erfindung werden darunter GTOs oder GTO-ähnliche Bauelemente verstanden - anzugeben, die für sehr hohe Spannungen geeignet ist und sich durch einen vergleichsweise einfachen Aufbau auszeichnet.

## DARSTELLUNG DER ERFINDUNG

Die Aufgabe wird bei einer Schaltungsanordnung der eingangs genannten Art dadurch gelöst, dass

(e) die Aenderungsgeschwindigkeit des Gatestromes $dI_G/dt$so gewählt ist, dass die Schaltverzögerungszeiten $t_d$ der einzelnen GTO-Bauelemente beim Ein- bzw. Abschalten kleiner oder gleich 2 $\mu$s sind; und

(f) die Grösse der Induktivitäten so gewählt ist, dass die Anstiegsgeschwindigkeit des Durchlassstromes dl/dt beim Einschalten grösser gleich 1 kA/$\mu$s ist.

Das Grundkonzept der erfindungsgemässen Lösung lässt sich wie folgt erklären:

Wie bereits eingangs erwähnt, liegt ein massgebliches Problem bei der Serieschaltung von GTOs oder GTO-ähnlichen Bauelementen in den unterschiedlich langen Schaltverzögerungszeiten $t_d$ der einzelnen Bauelemente, die zu Zeitdifferenzen DELTA$t_d$ beim Schalten führen.

Dass diese kritischen Unterschiede DELTA$t_d$ in den Schaltverzögerungszeiten durch eine beschleunigte Ansteuerung verringert werden können, ist in der eingangs genannten Druckschrift zwar schon erkannt worden. Es wurde jedoch an der herkömmlichen Ansteuertechnik (mit einer relativ hohen Gatekreis-Induktivität von $L_G \approx 300$ nH) festgehalten und die Aenderungsgeschwindigkeit des Gatestromes $I_G$, nämlich $dI_G/dt$, nur um das 1,3- bzw. 1,9-fache erhöht. Weiterhin wurde auch bereits erkannt, dass die Spike-Spannung bei einem solchen Betrieb ansteigt, sodass besonders kleine Induktivitäten im Snubberkreis notwendig werden.

Bei der vorliegenden Erfindung wird nun zunächst vorgeschlagen, das $dI_G/dt$ mindestens so weit zu steigern, dass die Verzögerungszeiten $t_d$ in den Bereich von 1-2 $\mu$s und weniger rücken. $DELTAt_d$ wird dann zwangsläufig kleiner $\pm 100$ ns - $\pm 200$ ns ausfallen.

Weiteres wichtiges Merkmal der Erfindung ist ein entsprechend schnelleres Einschalten der GTO-Bauelemente, sodass (a) $dI/dt$ erhöht werden kann und (b) das Einschalten bei auftretenden Schaltverzögerungen unproblematisch wird. Zu (b) tragen folgende Effekte im Besonderen bei: Wird ein GTO um $DELTAt_d$ später eingeschaltet, als die anderen, so ist der Stromanstieg im Hauptzweig bereits eingeleitet worden. Der Strom $I_{on}$ = $dI/dt$ x $DELTAt_d$ (bei zeitunabhängiger Induktivität) läuft dann über den Snubber des verzögerten GTO und belastet dessen Snubber-Diode in Vorwärtsrichtung. Der verzögerte GTO muss infolgedessen nicht nur gegen $I_{on}$ ohne ($dI/dt$)-Begrenzung einschalten, sondern zudem erst noch die eigene Snubber-Diode freiräumen (reverse recovery). In der eingangs genannten Druckschrift werden deshalb die ($dI/dt$)-Drosseln $L_1$ und $L_2$ (L1 und L2 in Fig. 1 dieser Anmeldung) als Sättigungsdrosseln ausgeführt.

Macht man nun $DELTAt_d$ klein und gleichzeitig den GTO unempfindlich gegen Ueberlastung durch $dI/dt$ beim Einschalten, kann auf die Sättigungsdrosseln verzichtet und der Snubber gegenüber dem bisherigen Fall (mit $DELTAt_d \geq 2\ \mu$s) erheblich reduziert werden, denn die Ueberspannungen beim Einschalten bleiben klein:

$$DELTAU_{on} = (1/CS) \int Idt = (1/CS) \int_0^{DELTAt_d} (dI/dt)tdt =$$

$$(1/2CS)(dI/dt)(DELTAt_d)^2$$

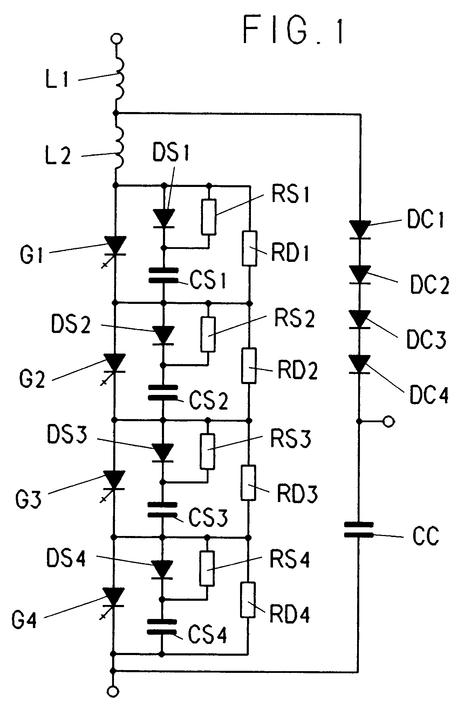

(mit z.B. CS = 3 $\mu$F, $dI/dt$ = 3 kA/$\mu$s, $DELTAt_d$ = 100 ns ergibt sich: $DELTAU_{on}$ = 5 V). Auf sättigende Induktivitäten und den gemeinsamen Clamp aus Clamp-Dioden und Clamp-Kondensator (DC1,...,DC4 und CC in Fig. 1)kann folglich verzichtet werden.

Um aber die Energie aus den Induktivitäten für die ($dI/dt$)-Begrenzung in den CS nicht zu übermässigen Ueberspannungen führen zu lassen, muss $dI/dt$ von den 500 A/$\mu$s bei herkömmlichen Schaltungen auf Werte $\geq 1$ kA/$\mu$s, vorzugsweise $\geq 3$ kA/$\mu$s, erhöht werden. Dies wird ermöglicht durch die schnellere Ansteuerung beim Einschalten.

Bei einer ersten bevorzugten Ausführungsform der Erfindung wird mit einer Reduktion der Grösse der Snubber-Kondensatoren CS die Anstiegsgeschwindigkeit der Sperrspannung beim Abschalten ($dV/dt$) auf Werte grösser oder gleich 500 V/$\mu$s, vorzugsweise 1 kV/$\mu$s gesteigert. Mit einem $DELTAt_d \leq \pm 200$ ns ergibt dies Spannungsunsymmetrien nach dem Abschalten von $DELTAU_{off}$ = $DELTAt_d$ x ($dV/dt$) $\leq \pm 200$ V, die bei einer periodischen Spitzensperrspannung $V_{DRM} \geq 3{,}0$ kV ohne nachteiligen Einfluss sind.

Eine andere vorteilhafte Ausführungsform der Erfindung zeichnet sich dadurch aus, dass jedem der GTO-Bauelemente eine Avalanchediode als Clamp parallelgeschaltet ist. Auf diese Weise können unerwünschte Spitzenspannungen einfach und wirkungsvoll begrenzt werden.

Weitere Ausführungsformen ergeben sich aus den Unteransprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig. 1     eine Serieschaltung von GTOs nach dem Stand der Technik;

Fig. 2     eine Serieschaltung mit GTO-Bauelementen gemäss einer ersten bevorzugten Ausführungsform der Erfindung;

Fig. 3     eine mögliche prinzipielle Ausführungsform eines Gate-Units zum Abschalten der GTO-Bauelemente aus Fig. 2;

Fig. 4     eine mögliche prinzipielle Ausführungsform eines Gate-Units zum Einschalten der GTO-Bauelemente aus Fig. 2;

Fig. 5     das Prinzip der Verriegelung der GTO-Bauelemente in unterschiedlichen Hälften eines Brückenzwieges gemäss einer zweiten bevorzugten Ausführungsform der Erfindung; und

Fig. 6   die parallele Anordnung mehrerer GTO-Bauelemente innerhalb der Serieschaltung gemäss einer dritten bevorzugten Ausführungsform der Erfindung.

WEGE ZUR AUSFÜHRUNG DER ERFINDUNG

Der Stand der Technik bezüglich der Serieschaltung von GTOs, wie er sich aus der eingangs genannten Druckschrift ergibt, ist in Fig. 1 wiedergegeben. Der dort dargestellte Arm eines Hochspannungs-GTO-Inverters umfasst vier in Serie geschaltete GTO-Bauelemente G1,...,G4 in Form von rückwärtsleitenden (2,5kV/2kA)-GTO-Thyristoren. Jedem der GTO-Bauelemente G1,...,G4 ist ein separater Snubber zur (dV/dt)-Begrenzung parallelgeschaltet, der jeweils in bekannter Weise aus einer Snubber-Diode (DS1,...,DS4), einem dazu parallelen Snubber-Widerstand (RS1,...,RS4) und einem in Serie liegenden Snubber-Kondensator (CS1,...,CS4; Kapazität: jeweils 4 $\mu$F) besteht.

Parallel zu den Snubbern sind zusätzlich einzelne Spannungsverteil-Widerstände RD1,...,RD4 vorgesehen, die eine gleichmässige Aufteilung der statischen Spannung auf die einzelnen Bauelemente gewährleisten sollen. In Serie mit den GTO-Bauelementen G1,...,G4 liegt eine sättigende Induktivität L2, welche die Belastung der Snubber-Dioden DS1,...,DS4 beim "reverse recovery" verringert und zusammen mit einer weiteren sättigenden Induktivität L1 den Stromanstieg dI/dt beim Einschalten begrenzt. Parallel zu der GTO-Serieschaltung ist noch ein gemeinsamer Clamp angeordnet, der aus vier Clamp-Dioden DC1,...,DC4 und einem Clamp-Kondensator CC besteht.

Wie bereits erwähnt, werden bei dieser bekannten Schaltung die GTO-Bauelemente G1,...,G4 auf herkömmliche Weise, d.h. mit relativ hoher Gatekreis-Induktivität $L_G$ ($\approx$ 300 nH), angesteuert, sodass zur Begrenzung der dynamischen Strom- und Spannungswerte die sättigenden Induktivitäten L1 und L2 sowie der gemeinsame Clamp DC1,...,DC4, CC notwendig sind.

Die Erfindung geht hier einen anderen Weg: Durch ein beschleunigtes Ansteuern der einzelnen GTO-Bauelemente werden die Schaltverzögerungszeiten $t_d$ und damit auch die Unterschiede DELTA$t_d$ in den Zeiten verringert. Snubber-Kondensatoren und Induktivitäten zur Begrenzung von dI/dt können dann erheblich verkleinert werden. Auf sättigende Induktivitäten und einen gemeinsamen Clamp kann dabei ganz verzichtet werden.

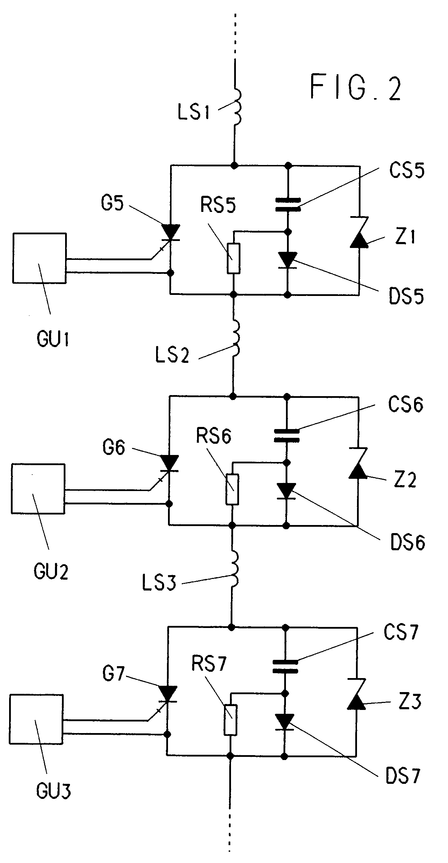

Eine bevorzugte Ausführungsform einer Serieschaltung nach der Erfindung ist in der Fig. 2 wiedergegeben. Eine Mehrzahl von GTO-Bauelementen G5,...,G7 ist dabei wiederum in Serie geschaltet. Jedes einzelne der GTO-Bauelemente G5,...,G7 wird durch einen zugehörigen Gate-Unit GU1,...,GU3 schnell angesteuert. Jedem einzelnen der GTO-Bauelemente G5,...,G7 ist in bekannter Weise ein Snubber aus Snubber-Kondensatoren CS5,...,CS7, Snubber-Dioden DS5,...,DS7 und Snubber-Widerständen RS5,...,RS7 parallelgeschaltet, sowie eine Avalanchediode Z1,...,Z3, auf deren Funktion später noch eingegangen wird. Darüberhinaus ist jedem der GTO-Bauelemente G5,...,G7 eine separate Induktivität LS1,...,LS3 zur (dI/dt)-Begrenzung vorgeschaltet.

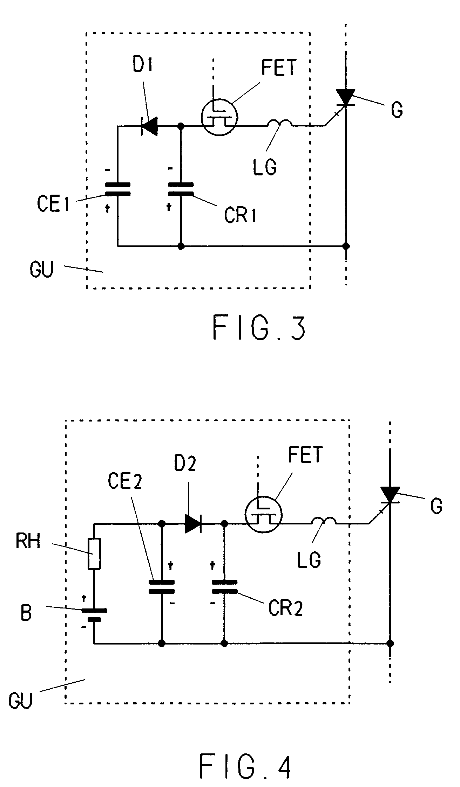

Für die Gate-Units GU1,...,GU3 aus Fig. 2 kommen grundsätzlich die in Fig. 3 und 4 dargestellten Prinzipschaltungen in Betracht, wobei die Schaltung der Fig. 3 zum Abschalten, die Schaltung der Fig. 4 dagegen zum Einschalten verwendet wird.

Der zum einzelnen GTO-Bauelement G gehörende Gate-Unit GU der Fig. 3 umfasst die nicht vermeidbare Gatekreis-Induktivität $L_G$, einen Feldeffekt-Transistor FET zum Schalten des Gatestroms, einen ersten Kondensator CR1 mit hoher Spannung, parallel zu CR1 einen zweiten Kondensator CE1 mit niedriger Spannung, und eine zwischen CR1 und CE1 angeordnete erste Diode D1 zum Trennen der Spannungen beider Kondensatoren CR1 und CE1.

Der Gate-Unit der Fig. 3 arbeitet in einem quasiresonanten Betriebsmodus: Der erste Kondensator CR1 mit der hohen Spannung (vorzugsweise $\geq$100 V, z.B. 200 V) liefert, wenn er durch den Feldeffekt-Transistor FET auf den Ausgang des Gate-Unit GU geschaltet ist, zu Beginn einen trotz der vorhandenen Gatekreis-Induktivität $L_G$ schnell ansteigenden Gatestrom, der nach seiner Entladung durch den zweiten Kondensator CE1 über die längere Dauer des Abschaltvorgangs aufrechterhalten wird. Die Kapazität von CR1 wird dabei so bemessen, dass sie nach der Entladung einen Gatestrom aufgebaut hat, der dem maximal abschaltbaren Anodenstrom entspricht. Der relativ lang anhaltende Strom aus CE1 muss dann mit einer Spannung angeboten werden, die unterhalb der Avalanchespannung (15 - 25 V) der Gate-Kathoden-Strecke des GTO-Bauelements G liegt.

Zu der Gatekreis-Induktivität $L_G$ ist folgendes zu bemerken: Ein Grossteil der Gatekreis-Induktivität $L_G$ wird bei herkömmlichen Beschaltungen durch das Koaxialkabel zwischen Gate-Unit GU und dem äusseren Gateanschluss des GTO-Bauelements G erzeugt. Im GTO-Gehäuse selbst sind von den typischen Gesamtwert von 300 nH nur etwa 30 nH lokalisiert. Wird nun der Gate-Unit GU mit einem Flachbandleiter, wie z.B. er aus der EP-A1-0 381 849 bekannt ist, an das GTO-Bauelement G angeschlossen, lassen sich Gatekreis-Induktivitäten $L_G$ von insgesamt $\leq$ 50 nH verwirklichen, ohne dass die Gehäuse der GTO-Bauelemente G verändert werden müssen. Dies führt zu den erwünschten höheren Anstiegsgeschwindigkeiten des Gatestroms ($dI_G/dt$), die dann im Bereich $\geq$ 1 kA/$\mu$s liegen. Das GTO-Bauelement G wird auf diese Weise "hart" ausgeschaltet und die Schaltverzögerungszeit $t_d$ entsprechend verkürzt.

Der Gate-Unit GU der Fig. 4 realisiert ein "hartes" Einschalten des GTO-Bauelements G: Wenn der Feldeffekt-Transistor FET geschlossen wird, wird aus einem dritten Kondensator CR2 mit hoher Spannung (vorzugsweise $\geq$ 100 V) ein schnell ansteigender Gatestrom in das Gate des GTO-Bauelements G injiziert. Nach der Entladung des relativ kleinen Kondensators CR2 hält ein grösserer vierter Kondensator CE2 den Zündstrom über die geforderte Zeit aufrecht. CE2 hat auch hier eine kleine Spannung (typischerweise 15 V) im Vergleich zu CR2. Eine zweite Diode D2 trennt wiederum die beiden Kondensatoren CR2 und CE2. Der notwendige Haltestrom kommt schliesslich aus einer zusätzlichen Batterie B über einen Haltestrom-Widerstand RH.

Anlagen mit in Serie geschalteten Bauelementen unterliegen in der Regel höchsten Ansprüchen an die Funktionssicherheit. Der Ausfall eines Bausteins (GTO-Bauelement, Gate-Unit, Snubber etc..) darf in keinem Fall zum Ausfall der gesamten Anlage führen. Dies kann ohne weitergehende Massnahmen nur bedingt erreicht werden: Die fehlende Ansteuerung eines einzelnen GTO-Bauelements kann z.B. an dessen Snubber-Kondensator CS zu Ueberspannungen und so zu einer Zerstörung mit entsprechenden Folgen führen, wenn nicht der Snubber-Kondensator entsprechend den Durchbruchswerten des GTO-Bauelements überdimensioniert wird.

Desweiteren führt eine Erhöhung des ($dV/dt$)-Wertes durch Verkleinerung von CS bei gleichem $dI/dt$ wieder zu erheblichen Spitzensperrspannungen $V_{DRM}$ (z.B.: $dI/dt$ = 3 kA/$\mu$s, $V_{off}$ = 3 kV, also L = 1 $\mu$H; $dV/dt$ = 2 kV/$\mu$s, I = 3 kA, also CS = 1,5 $\mu$F bei Vernachlässigung des Tailstromes des GTO-Bauelements; damit ist: $V_{DRM}$ = $V_{off}$ + $I\sqrt{(L/C)}$ = 3 kV + 2,4 kV = 5,4 kV). Solche Werte sind äusserst unerfreulich, bedeuten sie doch eine starke Ueberdimensionierung der gesamten Anlage.

Ein Weg, diesem Problem zu begegnen, ist in der eingangs genannten Druckschrift mit dem gemeinsamen Clamp (Clamp-Dioden DC1,...,DC4, Clamp-Kondensator CC) begangen worden. Dieser Weg erfordert jedoch grosse Hochspannungskondensatoren und eine Begrenzung des "reverse recovery" der Clamp-Dioden DC1,...,DC4 durch die Induktivität L2. Ein anderer Weg ist, parallel zum Snubber eines jeden GTO-Bauelements einen separaten Clamp zu schalten. Der Clamp-Kondensator CC muss aber in diesem Fall gemäss der obigen Gleichung deutlich grösser sein als CS, im obigen Beispiel also mindestens 7,5 $\mu$F für $V_{DRM}$ $\leq$ 4 kV. Darüberhinaus wäre für diese Clamps eine Entladevorrichtung notwendig, die den Clamp-KOndensator CC immer wieder auf $V_{off}$ entlädt, wenn das GTO-Bauelement in den stationären Zuständen (ON oder OFF) ist.

Gemäss der in Fig. 2 gezeigten, bevorzugten Ausführungsform wird deshalb vorgeschlagen, die Funktion der Clamps durch die Avalanchedioden Z1,...,Z3 wahrnehmen zu lassen. In einer besonders bevorzugten Ausführung werden diese Avalanchedioden Z1,...,Z3 als schnelle Dioden ausgeführt, sodass sie gleichzeitig die Funktion der Antiparalleldiode zum GTO-Bauelement G5,...,G7 übernehmen.

Mit dieser Ausführung ergeben sich die folgenden Vorteile:

- Das GTO-Bauelement wird spannungsmässig nie überbeansprucht.
- Die Spannungsaufteilung darf kurzzeitig ungleichmässig sein, da jede einzelne GTO-Spannung separat überwacht wird.
- Der Clamp wird nur aktiv, wenn der Snubber die Energie nicht mehr aufnehmen kann.
- Bei Ausfall eines GTO-Bauelements stellt sich unter den verbliebenen GTO-Bauelementen von selbst ein neues Gleichgewicht ein.
- Bei Unterbrechung eines GTO-Bauelements wird der zugehörige Clamp überlastet und geht in den Kurzschluss.
- Die Induktivitäten LS1,...,LS3 dürfen - wie in Fig. 2 dargestellt - jedem einzelnen GTO-Bauelement zugeordnet werden, sodass sich die höchste Symmetrie und kleinste ($dV/dt$)-Werte aufgrund parasitärer Effekte (z.B. "reverse recovery" der Snubber-Dioden DS5,...,DS7) ergeben.
- Die Spannungsverteil-Widerstände (RD1,...,RD4 in Fig. 1) können sehr gross gewählt werden, eventuell sogar ganz entfallen.

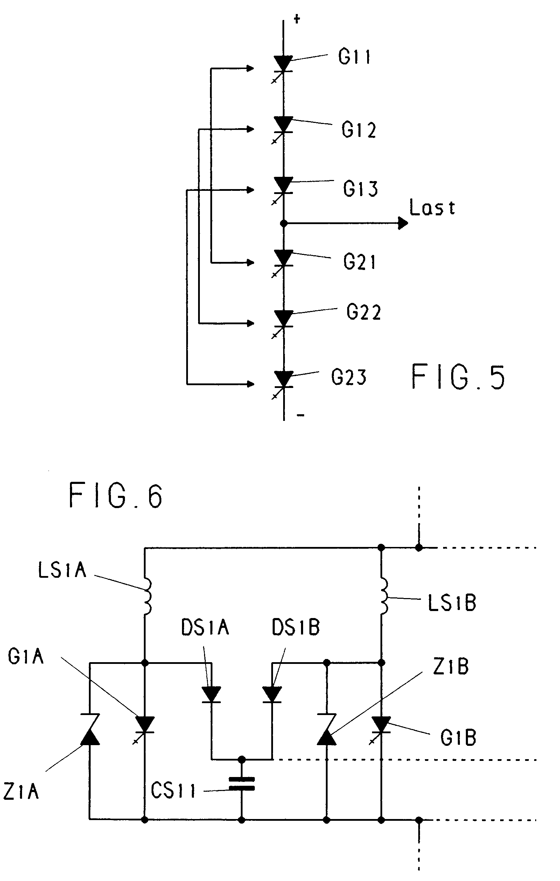

Eine weitere bevorzugte Ausführungsform der Erfindung betrifft die Verriegelung gegen Durchzünden (Fig. 5). Da Durchzünden unter den hohen Werten von $dI/dt$ und V katastrophale Folgen hätte, muss es vollkommen ausgeschlossen werden. Vorgeschlagen wird deshalb, bei einer Brücke, deren Zweige jeweils aus einer oberen und unteren Hälfte bestehen (jede Hälfte enthält die gleiche Anzahl von GTO-Bauelementen in Serieschaltung; siehe Fig. 5), je ein GTO-Bauelement G11,...,G13 der oberen Hälfte gemäss den in Fig. 5 eingezeichneten Doppelpfeilen mit einem entsprechenden GTO-Bauelement G21,...,G23 in der unteren Hälfte so zu verriegeln, dass die beiden nie zugleich eingeschaltet werden können.

Fehler in der Steuerung der Gesamtanlage werden so durch die Verriegelungen abgefangen, und beim Ausfall einer Verriegelung, der verbunden ist mit dem Auftreten eines Ansteuerfehlers, wird nur ein GTO-Bauelement fehlerhaft einschalten, sodass der betreffende Ast noch immer die volle Spannung blockieren kann (der Fall gleicht dem Ausfall eines GTO-Bauelements!). Selbstverständlich können dabei geeignete Zustands-Rückmeldungen in der Zentraleinheit für spätere Service-Zwecke protokolliert werden.

Schliesslich ist - wie in Fig. 6 dargestellt - eine Kombination aus Serie- und Parallelschaltung möglich. Hierdurch können noch höhere Ströme verarbeitet werden. Anstelle des einzelnen GTO-Bauelements G5,...,G7 aus Fig. 2 tritt dann eine Mehrzahl von parallelgeschalteten GTO-Bauelementen G1A, G1B, denen jeweils eigene Induktivitäten LS1A, LS1B zugeordnet sind. Die Snubber können für jedes der parallelen GTO-Bauelemente vollkommen separat ausgeführt oder - wie in Fig. 6 gezeigt - miteinander verkoppelt sein (separate Snubber-Dioden DS1A, DS1B; gemeinsamer Snubber-Kondensator CS11). Im letzteren Fall wird der Aufwand an Snubber-Kondensatoren reduziert, ohne an Zuverlässigkeit einzubüssen.

Anstelle eines Clamp sind auch in der Ausführungsform gemäss Fig. 6 für jedes der parallelgeschalteten GTO-Bauelemente G1A, G1B separate Avalanchedioden Z1A, Z1B vorgesehen.

Insgesamt ergibt sich mit der Erfindung eine Schaltungsanordnung mit in Serie geschalteten GTO-Bauelementen, die bei einfachem Aufbau und verringerter Dimensionierung der zusätzlichen Beschaltungselemente bis zu höchsten Spannungen und Strömen einsetzbar ist.

**Patentansprüche**

1. Schaltungsanordnung mit einer Serieschaltung von abschaltbaren Hochleistungs-Halbleiterbauelementen in Form von GTO-Bauelementen (G; G1,...,G7; G11,...,G23; G1A, G1B), wobei

   (a) jedem der GTO-Bauelemente (G; G1,...,G7; G11,...,G23; G1A, G1B) jeweils ein Gate-Unit (GU; GU1,...,GU3) zur Ansteuerung zugeordnet ist, welcher einen Gatestrom $I_G$ abgibt;

   (b) jedem der GTO-Bauelemente (G; G1,...,G7; G11,...,G23; G1A, G1B) jeweils ein Snubber parallelgeschaltet ist, welcher die Anstiegsgeschwindigkeit der Sperrspannung dV/dt beim Abschalten begrenzt und einen Snubber-Kondensator (CS1,...,CS7; C11) und eine Snubber-Diode (DS1,...,DS7; DS1A, DS1B) umfasst;

   (c) Induktivitäten (L1, L2; LS1,...,LS3; LS1A, LS1B) mit den GTO-Bauelementen (G; G1,...,G7; G11,...,G23; G1A, G1B) in Serie geschaltet sind, welche die Anstiegsgeschwindigkeit des Durchlassstromes dI/dt beim Einschalten begrenzen; und

   (d) die GTO-Bauelemente (G; G1,...,G7; G11,...,G23; G1A, G1B) während des Betriebs gemeinsam ein- bzw. abgeschaltet werden;

   dadurch gekennzeichnet, dass

   (e) die Aenderungsgeschwindigkeit des Gatestromes $dI_G/dt$so gewählt ist, dass die Schaltverzögerungszeiten $t_d$ der einzelnen GTO-Bauelemente (G; G5,...,G7; G11,...,G23; G1A, G1B) beim Ein- bzw. Abschalten kleiner oder gleich 2 $\mu$s sind; und

   (f) die Grösse der Induktivitäten (LS1,...,LS3; LS1A, LS1B) so gewählt ist, dass die Anstiegsgeschwindigkeit des Durchlassstromes dI/dt beim Einschalten grösser gleich 1 kA/$\mu$s ist.

2. Schaltungsanordnung nach Anspruch 1, dadurch gekennzeichnet, dass die Grösse der Induktivitäten (LS1,...,LS3; LS1A, LS1B) so gewählt ist, dass die Anstiegsgeschwindigkeit des Durchlassstromes dI/dt beim Einschalten grösser gleich 3 kA/$\mu$s ist.

3. Schaltungsanordnung nach Anspruch 1, dadurch gekennzeichnet, dass jedem der GTO-Bauelemente (G; G5,...,G7; G11,...,G23; G1A, G1B) eine Avalanchediode (Z1,...,Z3; Z1A, Z1B) als Clamp parallelgeschaltet ist.

4. Schaltungsanordnung nach Anspruch 3, dadurch gekennzeichnet, dass die Induktivitäten (LS1,...,LS3; LS1A, LS1B) jedem einzelnen der GTO-Bauelemente (G; G5,...,G7; G11,...,G23; G1A, G1B) zugeordnet sind.

5. Schaltungsanordnung nach Anspruch 3, dadurch gekennzeichnet, dass die Avalanchedioden (Z1,...,Z3; Z1A, Z1B) als schnelle Dioden ausgeführt sind.

6. Schaltungsanordnung nach Anspruch 1, dadurch gekennzeichnet, dass

   (a) die GTO-Bauelemente (G11,...,G23) die obere und untere Hälfte eines Brückenzweiges bilden, wobei jede Hälfte dieselbe Anzahl von Bauelementen umfasst; und

(b) jedes GTO-Bauelement (G11,...,G13) der oberen Hälfte mit dem entsprechenden GTO-Bauelement (G21,...,G23) derart verriegelt ist, dass beide zugeordneten Bauelemente nie zugleich eingeschaltet werden können.

7. Schaltungsanordnung nach Anspruch 1, dadurch gekennzeichnet, dass in der Serieschaltung jedes GTO-Bauelement durch eine Parallelschaltung von wenigstens zwei gleichartigen GTO-Bauelementen (G1A, G1B) ersetzt ist.

8. Schaltungsanordnung nach Anspruch 7, dadurch gekennzeichnet, dass jedes der parallelgeschalteten GTO-Bauelemente (G1A, G1B) einen separaten Snubber aufweist.

9. Schaltungsanordnung nach Anspruch 7, dadurch gekennzeichnet, dass die Snubber der parallelgeschalteten GTO-Bauelemente (G1A, G1B) miteinander verkoppelt sind.

10. Schaltungsanordnung nach Anspruch 1, dadurch gekennzeichnet, dass die Grösse der Snubber-Kondensatoren (CS1,...,CS7; C11) so gewählt ist, dass die Anstiegsgeschwindigkeit der Sperrspannung $dV/dt$ beim Abschalten des Maximalstromes der GTO-Bauelemente (G; G5,...,G7; G11,...,G23; G1A, G1B) grösser gleich 500 V/$\mu$s, vorzugsweise 1 kV/$\mu$s, ist.

# FIG.1

FIG. 2

FIG.3

FIG.4

FIG.5

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0 379 900 (SIEMENS AG)<br>* Spalte 2, Zeile 28 - Spalte 3, Zeile 7; Abbildungen 1,2 *<br>--- | 1 | H03K17/10 |
| A | IEEE CONFERENCE RECORD OF THE1990 NINETEENTH POWER MODULATOR SYMPOSIUM<br>Bd. 19, 1990, NEW YORK US<br>Seiten 357 - 360;<br>NEL ET AL.: 'A series thyristor switch driving a multi-stage ferrite pulse compressor for copper-vapor-laser applications'<br>* das ganze Dokument *<br>--- | 1,2,10 | |
| A | IEEE TRANSACTIONS ON INDUSTRY APPLICATIONS.<br>Bd. 24, Nr. 1, NEW YORK US<br>Seiten 121 - 125;<br>BISWAS ET AL.: 'An autoprotective gate drive circuit for GTO thyristors'<br>01/02 1988<br>* Seite 123, rechte Spalte - Seite 125; Abbildung 7 *<br>--- | 1,2,10 | |
| A | BROWN BOVERI REVIEW.<br>Bd. 74, Nr. 7, Juli 1987, BADEN CH<br>Seiten 401 - 408;<br>SCHWEIZER ET AL.: 'Fast switching thyristors replace thyratrons in high-current applications'<br>* Seite 405, mittlere Spalte, Zeile 14 - Seite 407, linke Spalte, Zeile 19; Abbildungen 5,7 *<br>----- | 1,2,10 | **RECHERCHIERTE SACHGEBIETE (Int. Cl.5 )**<br><br>H03K<br>H02M |

Der vorliegende Recherchenbericht wurde für alle Patentansprüche erstellt

| Recherchenort | Abschlußdatum der Recherche | Prüfer |
|---|---|---|
| DEN HAAG | 16 DEZEMBER 1991 | CANTARELLI R.J.H. |